# EUROPÄISCHE PATENTSCHRIFT

(11) **EP 2 507 748 B1**
(45) Veröffentlichungstag und Bekanntmachung des Hinweises auf die Patenterteilung: **10.12.2014**
(21) Anmeldenummer: 10765751.2
(22) Anmeldetag: 27.09.2010
(51) Int. Cl.: G06K 19/077, H01L 21/60

(54) **VERFAHREN ZUR KONTAKTIERUNG EINES CHIPS**
METHOD FOR MAKING CONTACT WITH A CHIP
PROCÉDÉ DE MISE EN CONTACT D'UNE PUCE

(30) Priorität: 30.11.2009 DE 102009056122
(43) Veröffentlichungstag der Anmeldung: 10.10.2012
(73) Patentinhaber: Smartrac IP B.V., 1077 XX Amsterdam (NL)
(72) Erfinder: RIETZLER, Manfred, 87616 Marktoberdorf (DE); LANG, Ulrich, Bangkok 10110 (TH)
(74) Vertreter: von den Steinen, Axel
(86) Internationale Anmeldenummer: PCT/EP2010/005882
(87) Internationale Veröffentlichungsnummer: WO 2011/063872

(56) Entgegenhaltungen:
- WO-A1-2006/002335
- US-A1- 2002 003 496
- US-B1- 6 891 110

## Beschreibung

Die Erfindung betrifft ein Verfahren zur Kontaktierung eines Chips mit einer Leiteranordnung sowie eine Leiteranordnung, insbesondere Transponderantenne, Zwischenträger oder dergleichen, mit einem Trägersubstrat zur Aufnahme des Chips und einem Chip mit darin ausgebildeten Chipanschlussflächen, wobei auf dem Trägersubstrat eine Leitermaterialschicht ausgebildet wird, wobei die Leitermaterialschicht eine Leiteranordnung mit zumindest zwei Leitern ausbildet, die in einem Chipkontaktbereich miteinander verbunden sind, wobei in dem Chipkontaktbereich ein Isolierspalt ausgebildet wird, derart, dass voneinander elektrisch isolierte Leiteranschlussflächen der Leiter gebildet werden, und wobei die Chipanschlussflächen mit den Leiteranschlussflächen kontaktiert werden.

Derartige Verfahren zur Kontaktierung eines Chips werden regelmäßig im Bereich der RFID-Technik angewandt, beispielsweise bei der Herstellung von Transponderetiketten. Ein Trägersubstrat zur Herstellung der Transponderetiketten ist aus einem Kunststoffmaterial in der Art einer dünnen Folie gebildet und dient insbesondere zur Aufnahme einer Transponderantenne. Die Transponderantenne kann grundsätzlich durch Ätzen, Aufdrucken oder in Drahtverlegetechnik auf dem Trägersubstrat ausgebildet werden. Bei einer in Ätztechnik ausgebildeten Antenne wird ein Chip mit daran ausgebildeten Chipanschlussflächen unmittelbar auf Leiteranschlussflächen der Antenne platziert und mit diesen elektrisch leitend verbunden bzw. kontaktiert. Alternativ kann der Chip mit einem Zwischenträger kontaktiert werden, der ebenfalls aus einem Trägersubstrat mit Leiteranschlussflächen ausgebildet ist und vergleichsweise große Antennenleiteranschlussflächen aufweist, die wiederum mit beispielsweise in Drahtverlegetechnik ausgebildeten Antennenleitern kontaktiert werden können. Der Zwischenträger mit dem Chip entspricht demnach einem Chipmodul, welches aufgrund der großen Antennenleiteranschlussflächen besonders einfach zu platzieren und zu kontaktieren ist.

Ein Problem bei der direkten Kontaktierung des Chips mit Leiteranschlussflächen ist dessen genaue Positionierung. Die Leiteranschlussflächen sind durch einen in Ätztechnik ausgebildeten Isolierspalt voneinander getrennt, wobei der Chip bei seiner Positionierung den Isolierspalt überspannt und mit seinen jeweiligen Chipanschlussflächen vollflächig auf den Leiteranschlussflächen zur Anlage gelangt. Je nach Material einer Leitermaterialschicht ist eine Breite des Isolierspalts mit den bekannten Ätzverfahren nicht unbegrenzt miniaturisierbar, insbesondere da das Ätzverfahren eine unscharfe bzw. unregelmäßige Kontur der Leiteranschlussflächen zur Folge hat. Der Chip muss daher relativ genau mit seinen Chipanschlussflächen auf den Leiteranschlussflächen positioniert werden, wenn die Chipanschlussflächen nicht in dem unregelmäßigen Randbereich der Leiteranschlussflächen aufliegen sollen. Es bestünde zwar die Möglichkeit, Leiteranschlussflächen mit einer vergleichsweise regelmäßigen Kontur auszubilden, wenn beispielsweise Kupfer zur Ausbildung der Leitermaterialschicht verwendet würde, jedoch ist Kupfer gegenüber anderen Materialien vergleichsweise teuer und somit nicht zur Herstellung von Leiteranordnungen in großen Stückzahlen, wie dies beispielsweise bei Etiketten der Fall ist, geeignet.

Die derzeit für RFID-Etiketten verwendeten Chips weisen regelmäßig eine Kantenlänge von circa 600 µm auf, so dass eine ausreichend genaue Positionierung des Chips auf den durch den Isolierspalt beabstandeten Leiteranschlussflächen innerhalb vertretbarer Toleranzen noch möglich ist. So kann beispielsweise eine Relativposition des Chips quer zum Isolierspalt um circa 80 µm variieren. Durch die fortschreitende technische Entwicklung besteht die absehbare Möglichkeit, Chips mit einer Kantenlänge von bis zu 300 µm herzustellen. Diese Chips erfordern, selbst bei einer Verringerung der Breite des Isolierspalts und der Chipanschlussflächen, eine weitaus höhere Positioniergenauigkeit mit einer Positioniertoleranz von beispielsweise circa 15 µm. Diese geringe Positioniertoleranz wird durch die Breite des Isolierspalts bestimmt, der im Rahmen des bekannten Ätzverfahrens nicht beliebig miniaturisierbar ist. Das Dokument WO2006/002335 A1 zeigt ein Verfahren zur Kontaktierung eines Chips mit den Merkmalen des Oberbegriffs der Anspruchs 1.

Der vorliegenden Erfindung liegt die Aufgabe zugrunde, ein Verfahren zur Kontaktierung eines Chips mit einer Leiteranordnung bzw. eine Leiteranordnung vorzuschlagen, das bzw. die eine verringerte Positioniergenauigkeit für einen Chip auf Leiteranschlussflächen erfordert.

Diese Aufgabe wird durch ein Verfahren mit den Merkmalen des Anspruchs 1 gelöst.

Bei dem erfindungsgemäßen Verfahren zur Kontaktierung eines Chips mit einer Leiteranordnung, insbesondere Transponderantenne, Zwischenträger oder dergleichen, mit einem Trägersubstrat zur Aufnahme des Chips und einem Chip mit daran ausgebildeten Chipanschlussflächen, wird auf dem Trägersubstrat eine Leitermaterialschicht ausgebildet, wobei die Leitermaterialschicht eine Leiteranordnung mit zumindest zwei Leitern ausbildet, die in einem Chipkontaktbereich miteinander verbunden sind, wobei im Chipkontaktbereich ein Isolierspalt ausgebildet wird, derart, dass voneinander elektrisch isolierte Leiteranschlussflächen der Leiter gebildet werden, wobei die Chipanschlussflächen mit den Leiteranschlussflächen kontaktiert werden, und wobei der Isolierspalt durch Abtrag der Leitermaterialschicht mittels eines Lasers ausgebildet wird.

Demnach wird auf dem Trägersubstrat eine Leitermaterialschicht ausgebildet, auf welche in einem weiteren Prozess ein Chip mit mindestens zwei Anschlussflächen aufgesetzt und kontaktiert wird, wobei der Isolierspalt, über welchem der Chip aufgesetzt wird, mittels eines Lasers ausgebildet und strukturiert wird. Das erfindungsgemäße Verfahren ermöglicht so die Ausbildung eines Isolierspalts mit einer scharfen, gleichmäßigen Kontur, so dass eine fertigungstechnisch notwendige Breite des Isolierspalts gegenüber einem in einem Ätzverfahren hergestellten Isolierspalt deutlich verringert werden kann. Folglich wird eine Positioniertoleranz für einen Chip vergrößert, wodurch die Anforderungen an eine Positioniergenauigkeit des Chips sinken. Durch die geringere erforderliche Positioniergenauigkeit können unter anderem die Kosten für die Montage des Chips gesenkt werden. Die Leitermaterialschicht bzw. die beiden Leiter werden weiterhin, sofern dies notwendig ist, in einem konventionellen Ätzverfahren ausgebildet. Lediglich im Chipkontaktbereich, d.h. dem Bereich, der von dem Chip nach einer Positionierung überdeckt wird, sind die beiden Leiter noch miteinander verbunden. In dem nachfolgenden neuen Verfahrensschritt wird dann im Chipkontaktbereich der Isolierspalt durch einen vollständigen Abtrag der Leitermaterialschicht bis hin zu einer Oberfläche des Trägersubstrats mittels des Lasers ausgebildet. Da der Laser auf die Leitermaterialschicht fokussierbar ist, erfolgt der Abtrag, ohne das Trägersubstrat wesentlich zu beschädigen oder zu manipulieren. Der Isolierspalt ist mittels des Lasers unabhängig von einer Dicke der Leitermaterialschicht sauber und genau ausbildbar, wobei im Gegensatz dazu bei einem Ätzverfahren ein so genanntes Hinterätzen der Kontur, insbesondere bei größeren Schichtdicken, unerwünscht auftritt.

Als ein weiterer Verfahrensschritt kann vorgesehen sein, dass eine Reinigung des Chipkontaktbereichs mittels einer Plasmabehandlung erfolgt, insbesondere um bei Verwendung von Aluminium als Leitermaterial das Aluminium-Oxid abzutragen. Eine Plasmabehandlung, wie beispielsweise eine Kathodenzerstäubung bzw. das so genannte Sputtern, kann einen Abtrag von Spänen oder Rückständen der Laserbehandlung bewirken. Vorteilhaft kann so eine hochreine Oberfläche der Leiteranschlussflächen erhalten werden.

In einem weiteren Verfahrensschritt kann vor oder nach einer Kontaktierung des Chips ein Auftrag von Klebermaterial auf den Chipkontaktbereich erfolgen. Das Klebermaterial kann als so genannter Underfiller-Kleber zur mechanischen Befestigung des Chips auf dem Trägersubstrat dienen. Das Klebermaterial kann mittels eines Dosiergeräts direkt auf den Chipkontaktbereich oder in einen Zwischenraum zwischen Chip und Trägersubstrat aufgebracht und nachfolgend ausgehärtet werden. Als Klebermaterial kann leitender, nicht leitender oder anisotroper bzw. flüssiger oder pastöser Kleber verwendet werden. Erfindungsgemäss wird vor einer Platzierung des Chips eine Relativposition des Isolierspalts mittels einer Bildbearbeitungsvorrichtung ermittelt. Eine genaue Positionierung des Chips relativ zum Isolierspalt, wie sie bei Chips mit besonders kleinen Kantenlängen notwendig ist, wird so einfach ermöglicht.

Alternativ kann vor einer Platzierung des Chips eine Relativposition von Außenbereichen des Chipkontaktbereichs mittels einer Bildverarbeitungsvorrichtung ermittelt werden, insbesondere eine Außenkontur der Leiteranschlussflächen mit dem in der Außenkontur sichtbaren Isolierspalt. Somit kann die Lage des Isolierspalts bestimmt werden, auch wenn bereits im Chipkontaktbereich Klebermaterial oder auch andere den Isolierspalt bedeckende Elemente zuvor aufgebracht wurden.

Demnach kann eine Ermittlung der Relativposition von Außenbereichen des Chipkontaktbereichs vor oder nach einem Auftrag von Klebermaterial auf dem Chipkontaktbereich erfolgen. Dies ist insofern möglich, als die erforderliche Chipposition immer am Isolierspalt orientiert ist.

Eine einfache Bestimmung der erforderlichen Chipposition wird möglich, wenn die Chipposition auf dem Trägersubstrat mittels einer Maschinensteuerung aus Daten der Bildverarbeitungseinrichtung berechnet wird. Beispielsweise kann dann die Korrektur einer Chipposition bei einer Lageabweichung des Isolierspalts einfach erfolgen. Nach der so vereinfachten, genauen Positionierung des Chips kann eine Kontaktierung des Chips bzw. der Chipanschlussflächen mit den Leiteranschlussflächen des Trägersubstrats mittels Druck und Temperatur bzw. Ultraschall und Temperatureinwirkung durchgeführt werden.

Um für die Laserbehandlung nachteilige Höhendifferenzen des Trägersubstrats relativ zum Laser zu vermeiden, beispielsweise in der Art einer Wellenbildung des Trägersubstrats, kann das Trägersubstrat zur Ausbildung des Isolierspalts mittels eines Flüssigkeitsfilms auf einer Platte fixiert werden. Zum Beispiel kann zwischen einer ebenen Platte und einem folienartigen Trägersubstrat ein Wasserfilm vorgesehen sein, der eine Adhäsionsschicht ausbildet. Das Trägersubstrat liegt dann auf der Platte eben auf, so dass ein Fokus des Lasers immer im Bereich der Leitermaterialschicht positioniert werden kann.

Auch kann das Trägersubstrat zur Ausbildung des Isolierspalts mittels Unterdruck auf einer Platte fixiert werden. Die Platte kann dazu mit einem Bohrungsraster versehen sein, wobei an den Bohrungen ein Vakuum angelegt bzw. ein Ansaugen von Luft bewirkt wird, welches wiederum ein Ansaugen des Trägersubstrats auf die ebene Platte bewirkt.

Die Leiteranordnung kann besonders kostengünstig hergestellt werden, wenn die Leitermaterialschicht aus Aluminium gebildet wird. Aluminium ist gegenüber anderen Materialien zur Ausbildung einer Leitermaterialschicht vergleichsweise preisgünstig erhältlich. Alternativ ist die Leitermaterialschicht auch aus dem vergleichsweise teureren Kupfer oder anderen geeigneten Materialien herstellbar.

In einer Ausführungsform kann die Leiteranordnung als eine Transponderantenne ausgebildet werden. Das Trägersubstrat kann dann als ein Antennensubstrat dienen, wobei die Transponderantenne als ein Dipol oder in Art einer ebenen Spule ausgebildet sein kann. So kann eine Antenne im UHF-Bereich ausgeführt sein (Dipol). Somit gibt es zwei elektrisch getrennte Antennenbereiche, die durch den Chip im Bereich des Isolierspaltes elektrisch über den Chip verbunden sind. Auch kann eine hochfrequente Transponderantenne als Spule bzw. Mehrfachschleife ausgeführt sein, somit ist die Leitermaterialschicht durchgängig geschlossen und nur im Bereich des Isolierspaltes elektrisch offen.

Auch kann mittels des Lasers besonders vorteilhaft eine Frequenzabstimmung der Transponderantenne durch Abtrag der Leitermaterialschicht oder durch Abtrennen von Leiterabschnitten erfolgen. So ist es möglich, für verschiedene Arten von Transpondern bzw. Chips eine jeweils identische Transponderantenne auszubilden und eine Frequenzanpassung der Transponderantenne durch Kürzen von Leitersträngen zu bewirken. Dies kann sinnvollerweise in einem Schritt mit der Ausbildung des Isolierspalts erfolgen. Die Frequenzabstimmung kann auch erfolgen, indem Bereiche der Transponderantenne mittels Laser komplett vom eigentlichen Antennenleiter abgetrennt werden. Man schafft somit eine parasitäre Kapazität, die Ohm-elektrisch nicht mit der Antenne verbunden ist, aber über den schmalen Isolierspalt einen kapazitiven Effekt bewirkt und somit die Resonanzfrequenz der Transponderantenne beeinflusst.

Die Transponderantenne kann weiter mit vordefinierten Trennbereichen ausgebildet werden, welche mittels des Lasers trennbar sind. Die Trennbereiche können dünner oder weniger breit als ein regelmäßiger Leiterquerschnitt ausgebildet sein, so dass sie leichter zu trennen sind.

In einer weiteren Ausführungsform kann die Leiteranordnung als ein Zwischenträger ausgebildet sein. Eine Außenkontur einer Leitermaterialschicht des Zwischenträgers kann ebenfalls durch ein herkömmliches Ätzverfahren ausgebildet werden, wobei die Leitermaterialschicht dann ebenfalls mittels des Lasers zur Ausbildung zumindest zweier Leiteranschlussflächen abgetragen bzw. durchtrennt wird. Der Chip kann dann auf dem Zwischenträger platziert werden, wobei der Zwischenträger zusammen mit dem Chip als ein Chipmodul zur Verbindung mit einer Transponderantenne verwendet werden kann.

Vorteilhaft kann der Isolierspalt mit einer Spaltbreite von ≤20 µm ausgebildet werden. Der Isolierspalt ist damit gegenüber von in einem Ätzverfahren hergestellten Isolierspalten besonders schmal, wodurch sich die Leiteranordnung zur Aufnahme von Chips mit sehr kleinen Kantenlängen besonders gut eignet.

Auch können im Chipkontaktbereich zumindest vier isolierte Leiteranschlussflächen ausgebildet werden. Dies ist insofern vorteilhaft, wenn der Chip über eine entsprechende Anzahl Chipanschlussflächen verfügt, so dass die Leiteranschlussflächen als eine Auflage für den Chip dienen können. Auch ist es möglich, Leiteranschlussflächen neutral, d.h. ohne eine weiterführende elektrische Leiterverbindung, auszubilden. Grundsätzlich kann eine nahezu beliebige Anzahl von Leiteranschlussflächen ausgebildet werden.

Zu einer Herstellung von Leiteranordnungen in einer großen Stückzahl ist es vorteilhaft, wenn das Trägersubstrat als ein Folienstreifen mit einer Mehrzahl von in parallelen Reihen angeordneten Leiteranordnungen ausgebildet ist und relativ zum Laser an diesem vorbeibewegt wird. Der Folienstreifen kann beispielsweise auf einer Rolle bevorratet werden, wobei in voneinander unabhängigen oder in direkt aufeinander folgenden Arbeitsschritten eine Ausbildung des Isolierspalts und eine Kontaktierung des Chips erfolgen kann.

Auch kann vorteilhaft vor Kontaktierung eines Chips ein Chip-Zwischenträger kontaktiert werden. Die Verwendung eines Chip-Zwischenträgers ermöglicht die Ausbildung eines weniger genaueren und breiteren Isolierspalts.

Im Folgenden wird die Erfindung unter Bezugnahme auf die beigefügte Zeichnung näher erläutert.

Es zeigen:
- **Fig. 1**: eine Leiteranordnung mit einem darauf kontaktierten Chip nach dem Stand der Technik in einer Seitenansicht;
- **Fig. 2**: eine weitere Ausführungsform einer Leiteranordnung mit einem darauf kontaktierten Chip in einer Seitenansicht;
- **Fig. 3**: Leiteranschlussflächen nach dem Stand der Technik in einer Teilansicht;
- **Fig. 4**: eine Seitenansicht einer Laservorrichtung in einer schematischen Darstellung;
- **Fig. 5**: eine Mehrzahl von Leiteranordnungen auf einem Trägersubstrat;
- **Fig. 6**: einen ersten Verfahrensschritt in einer schematischen Darstellung;
- **Fig. 7**: einen zweiten Verfahrensschritt in einer schematischen Darstellung;
- **Fig. 8**: einen dritten Verfahrensschritt in einer schematischen Darstellung;
- **Fig. 9**: einen vierten Verfahrensschritt in einer schematischen Darstellung;
- **Fig. 10**: einen fünften Verfahrensschritt in einer schematischen Darstellung;
- **Fig. 11**: einen Zwischenträger mit einer Ausführungsform einer Leiteranordnung.

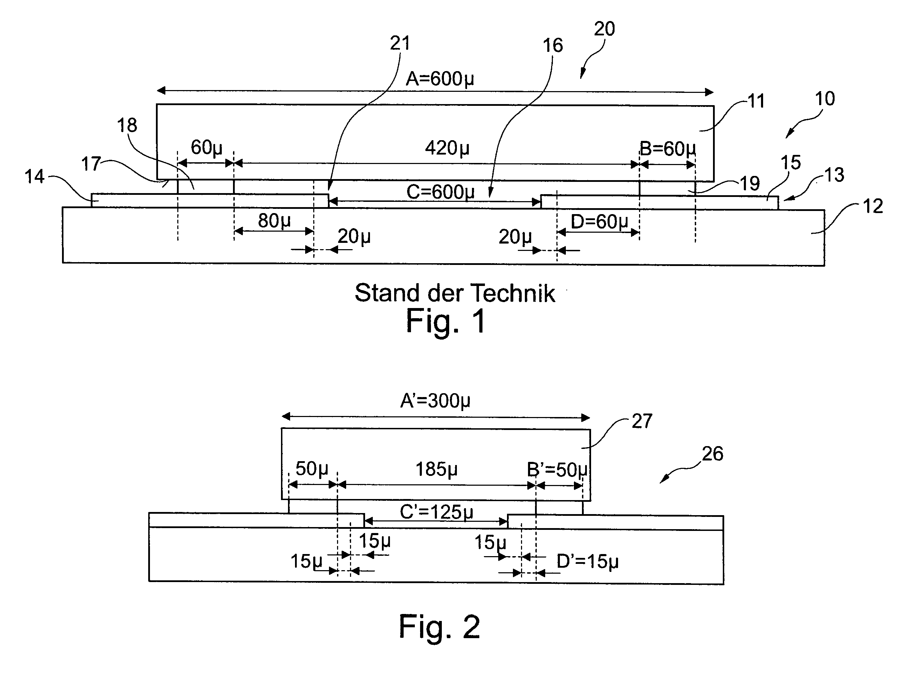

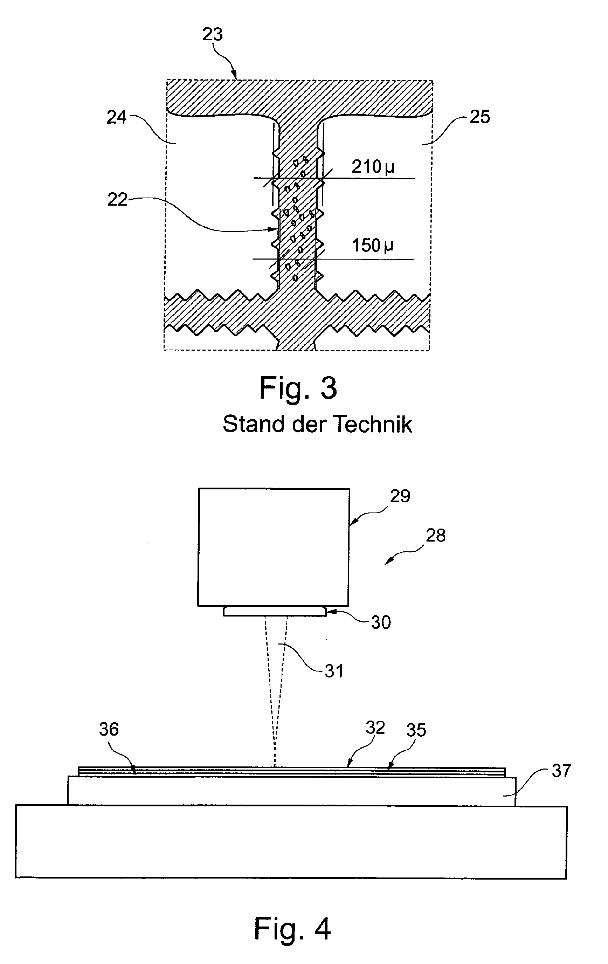

**Fig. 1** zeigt eine Leiteranordnung 10 mit einem darauf kontaktierten Chip 11 nach dem Stand der Technik. Die Leiteranordnung 10 umfasst ein Trägersubstrat 12 mit einer Leitermaterialschicht 13, die Leiteranschlussflächen 14 und 15 ausbildet. Die Leiteranschlussflächen 14 und 15 sind durch einen Isolierspalt 16 elektrisch voneinander getrennt. Weiter sind an einer Unterseite 17 des Chips 11 Chipanschlussflächen 18 und 19 ausgebildet, die auf den Leiteranschlussflächen 14 bzw. 15 angeordnet und mit diesen elektrisch leitend verbunden sind. Der Chip 11 überspannt dabei den Isolierspalt 16, wobei die Leiteranschlussflächen 14 und 15 einen möglichen Chipkontaktbereich 20 ausbilden, innerhalb dessen der Chip 11 mit den Leiteranschlussflächen 14 und 15 kontaktiert werden kann. Eine Kontaktierung der Leiteranschlussflächen 14 und 15 in einem Randbereich 21 ist nicht erwünscht, da der Randbereich 21 durch die Ausbildung des Isolierspalts 16 in einem Ätzverfahren unscharf bzw. mit einer unregelmäßigen Kontur 22, wie in **Fig. 3** beispielhaft dargestellt, ausgebildet ist. Ein dort gezeigter Isolierspalt 23 variiert in seiner Breite zwischen 150 und 210 µm zwischen Leiteranschlussflächen 24 und 25 aus Aluminium.

**Fig. 2** zeigt eine mögliche Anpassung einer Leiteranordnung 26 auf einen Chip 27 mit einer gegenüber dem Chip 11 verringerten Kantenlänge A'. Die Leiteranordnung 26 und der Chip 27 weisen grundsätzlich den gleichen Aufbau gemäß der Leiteranordnung 10 bzw. dem Chip 11 in **Fig. 1** auf. Neben der Kantenlänge A' sind hier im Unterschied zur Leiteranordnung 10 und zum Chip 11 eine Chipanschlussflächenbreite B' und eine Isolierspaltbreite C' konstruktiv verringert. Eine weitere Verringerung der Isolierspaltbreite C' ist aufgrund der in **Fig. 3** gezeigten Unschärfe der Kontur 22, wie sie bei einem Ätzverfahren entstehen kann, nicht möglich. Der Chip 27 kann daher nur innerhalb einer relativ geringen Positioniertoleranz D' mit der Leiteranordnung 26 kontaktiert werden.

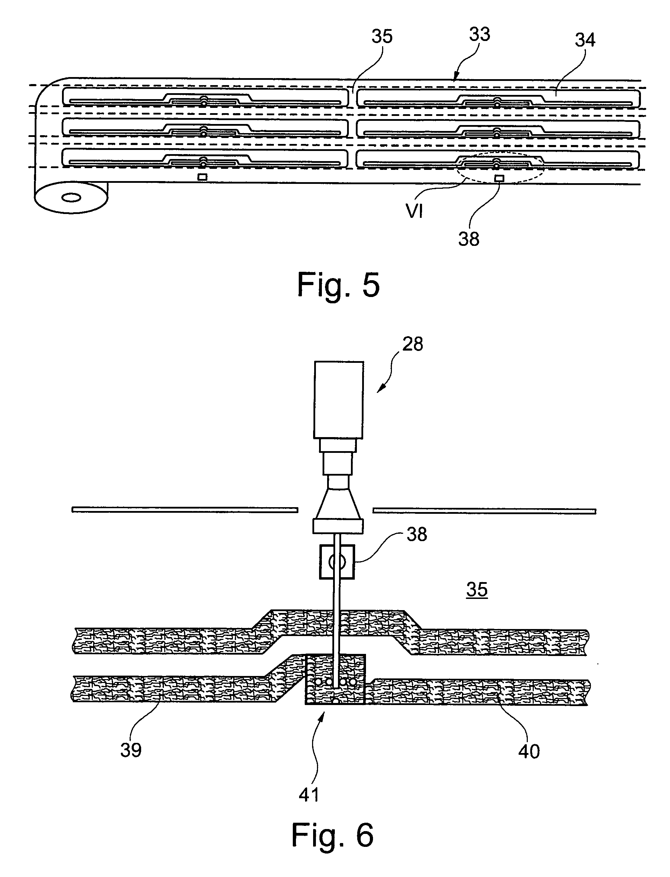

**Fig. 4** zeigt eine beispielhafte Laservorrichtung 28 zur Ausbildung einer hier nicht näher dargestellten erfindungsgemäßen Leiteranordnung. Die Laservorrichtung 28 ist aus einem Laser 29 mit einem hier nicht sichtbaren Scannersystem gebildet. Der Laser 29 verfügt über eine Optik 30, die einen Laserstrahl 31 auf eine Leitermaterialschicht 32 aus Aluminium fokussieren kann. Die Leitermaterialschicht 32 bildet entsprechend der in **Fig. 5** gezeigten Darstellung eine Reihe von Leiteranordnungen 33 aus, welche ihrerseits jeweils eine Transponderantenne 34 ausbilden. Die Leiteranordnungen 33 sind auf einem Trägersubstrat 35 angeordnet, wobei das Trägersubstrat 35, wie aus **Fig. 4** zu ersehen ist, mittels eines Flüssigkeitsfilms 36 auf einer Glasplatte 37, insbesondere durch die Adhäsionskraft des Flüssigkeitsfilms, fixiert ist.

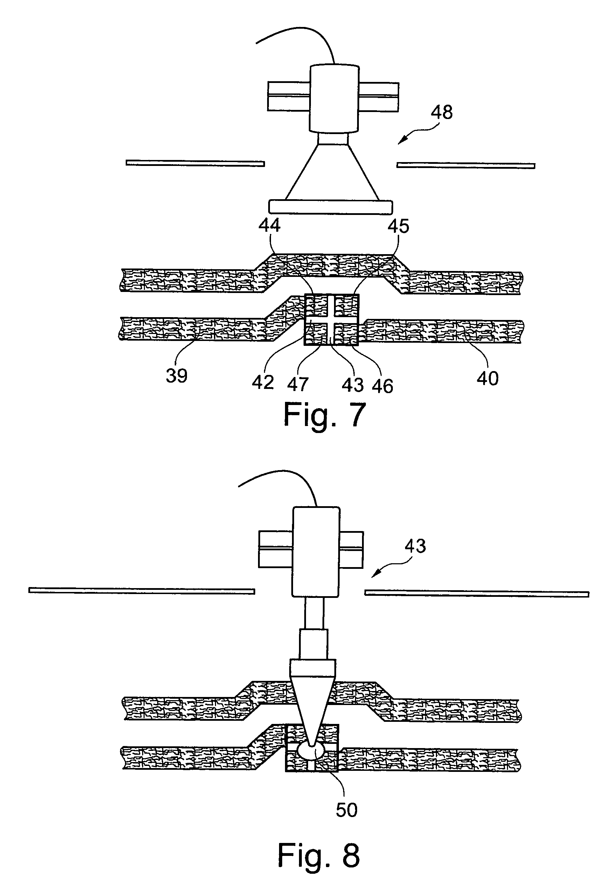

**Fig. 6** zeigt einen ersten Schritt des Verfahrens mit einem Ausschnitt VI. einer Transponderantenne 34 aus **Fig. 5**. Das Trägersubstrat 35 wird anhand einer Positioniermarke 38 bzw. die Transponderantenne 34 wird relativ zum Laser 29 ausgerichtet. Auf dem Trägersubstrat 35 sind ein erster Leiter 39 und ein zweiter Leiter 40 der Transponderantenne 34 ausgebildet. Beide Leiter 39 und 40 sind in einem Chipkontaktbereich 41 miteinander verbunden, wobei mittels des Laserstrahls 31 nunmehr ein Abtrag von Leitermaterial erfolgt, derart, dass Isolierspalte 42 und 43 ausgebildet werden, die wie in **Fig. 7** gezeigt, Leiteranschlussflächen 44 bis 47 ausbilden. Die Leiteranschlussfläche 44 ist dabei mit dem ersten Leiter 39 und die Leiteranschlussfläche 46 ist mit dem zweiten Leiter 40 elektrisch verbunden. Die Leiteranschlussflächen 45 und 47 sind hingegen nicht elektrisch kontaktiert und dienen alleine zur Abstützung eines zu kontaktierenden Chips. Nach der Ausbildung der Isolierspalte 42 und 43 erfolgt eine Reinigung des Chipkontaktbereichs 41 mittels einer Plasmabehandlung. Mit einer entsprechenden Vorrichtung 48 werden unter anderem mögliche Rückstände der Laserbehandlung entfernt.

Nachfolgend wird, wie in **Fig. 8** dargestellt, mit einer Dosiervorrichtung 49 ein Klebermaterial 50 auf den Chipkontaktbereich 41 appliziert.

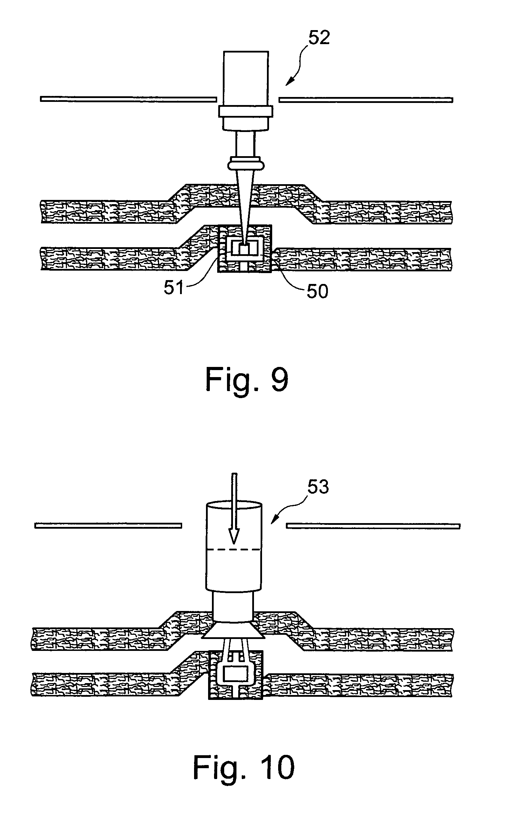

Danach wird ein Chip 51 auf die Leiteranschlussflächen 44 bis 47 platziert, wobei mittels eines hier nicht gezeigten Bildverarbeitungssystems eine Lage der Isolierspalte 42 und 43 ermittelt und eine genaue Kontaktposition für den Chip 51 berechnet wird. Eine Positioniervorrichtung 52 korrigiert entsprechende Positionsabweichungen. Nach der in **Fig. 9** gezeigten Platzierung des Chips 51 erfolgt die in **Fig. 10** dargestellte Kontaktierung des Chips 51 mit hier nicht ersichtlichen Chipanschlussflächen mit den Leiteranschlussflächen 44 bis 47. Die Kontaktierung erfolgt automatisch durch eine Vorrichtung 53 bzw. durch das so genannte Thermosonic-Verfahren mittels Ultraschall und Temperatur.

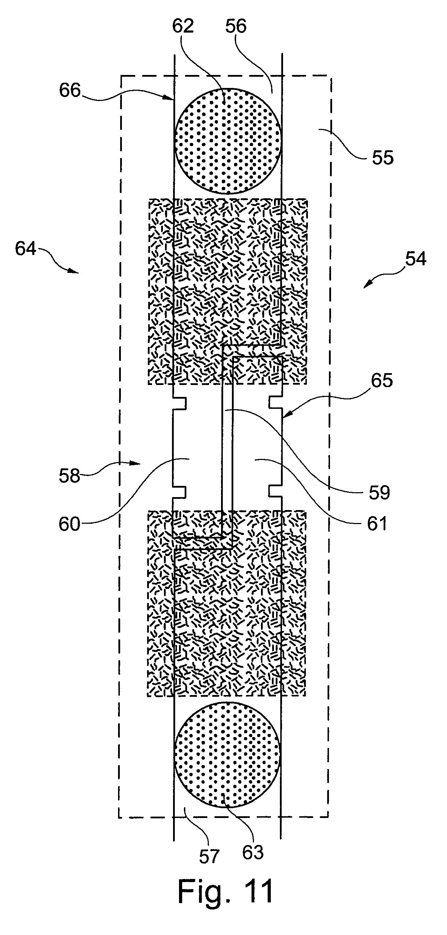

**Fig. 11** zeigt einen Zwischenträger 54 bzw. einen so genannten Strap, auf dem ein hier nicht dargestellter Chip mit Chipanschlussflächen kontaktiert werden kann. Der Zwischenträger 54 umfasst ein Trägersubstrat 55 mit einem ersten Leiter 56 und einem zweiten Leiter 57, wobei in einem Chipkontaktbereich 58 beide Leiter 56 und 57 durch einen Isolierspalt 59 getrennt sind und so Leiteranschlussflächen 60 und 61 ausbilden. Die Leiter 56 und 57 verfügen weiter über Antennenanschlussflächen 62 und 63, welche zur Kontaktierung mit einer hier nicht gezeigten Transponderantenne dienen können. Eine so ausgebildete Leiteranordnung 64 wurde zunächst in einem konventionellen Ätzverfahren mit einer Außenkontur 65 auf dem Trägersubstrat 55 ausgebildet, wobei nachfolgend eine Ausbildung des Isolierspalts 59 durch einen spaltförmigen Abtrag einer Leitermaterialschicht 66 mittels eines hier nicht gezeigten Lasers erfolgte.

## Patentansprüche

1. Verfahren zur Kontaktierung eines Chips mit einer Leiteranordnung, insbesondere Transponderantenne, Zwischenträger oder dergleichen, mit einem Trägersubstrat (35, 55) zur Aufnahme des Chips und einem Chip (51) mit daran ausgebildeten Chipanschlussflächen, wobei auf dem Trägersubstrat eine Leitermaterialschicht (32, 66) ausgebildet wird, wobei die Leitermaterialschicht eine Leiteranordnung (33, 64) mit zumindest zwei Leitern (39, 40 ,56, 57) ausbildet, die in einem Chipkontaktbereich (41, 58) miteinander verbunden sind, wobei in dem Chipkontaktbereich ein Isolierspalt (42, 43, 59) ausgebildet wird, derart, dass voneinander elektrisch isolierte Leiteranschlussflächen (44, 45, 46, 47,60, 61) der Leiter gebildet werden, wobei die Chipanschlussflächen mit den Leiteranschlussflächen kontaktiert werden, wobei der Isolierspalt durch Abtrag der Leitermaterialschicht mittels eines Lasers (29) ausgebildet wird,
**dadurch gekennzeichnet,**
**dass** vor einer Platzierung des Chips eine Relativposition des Isolierspalts mittels einer Bildverarbeitungsvorrichtung ermittelt wird.

2. Verfahren nach Anspruch 1,
**dadurch gekennzeichnet,**
**dass** eine Reinigung des Chipkontaktbereichs (41, 58) mittels einer Plasmabehandlung erfolgt.

3. Verfahren nach Anspruch 1 oder 2,
**dadurch gekennzeichnet,**
**dass** vor oder nach einer Kontaktierung des Chips (51) ein Auftrag von Klebermaterial (50) auf den Chipkontaktbereich (41, 58) erfolgt.

4. Verfahren nach einem der vorangehenden Ansprüche,
**dadurch gekennzeichnet,**
**dass** die Ermittlung der Relativposition vor oder nach einem Auftrag von Klebermaterial (50) auf den Chipkontaktbereich (41, 58) erfolgt.

5. Verfahren nach einem der vorangehenden Ansprüche,
**dadurch gekennzeichnet,**
**dass** eine Chipposition auf dem Trägersubstrat (35, 55) mittels einer Maschinensteuerung aus Daten der Bildverarbeitungsvorrichtung berechnet wird.

6. Verfahren nach einem der vorangehenden Ansprüche,
**dadurch gekennzeichnet,**
**dass** das Trägersubstrat (35, 55) zur Ausbildung des Isolierspalts (42, 43, 59) mittels eines Flüssigkeitsfilms (36) auf einer Platte (37) fixiert wird.

7. Verfahren nach einem der Ansprüche 1 bis 5,
**dadurch gekennzeichnet,**
**dass** das Trägersubstrat zur Ausbildung des Isolierspalts mittels Unterdruck auf einer Platte fixiert wird.

8. Verfahren nach einem der vorangehenden Ansprüche,
**dadurch gekennzeichnet,**
**dass** die Leitermaterialschicht (32, 66) aus Aluminium gebildet wird.

9. Verfahren nach einem der vorangehenden Ansprüche,
**dadurch gekennzeichnet,**
**dass** die Leiteranordnung (33) als eine Transponderantenne (34) ausgebildet wird.

10. Verfahren nach Anspruch 9,
**dadurch gekennzeichnet,**
**dass** eine Frequenzabstimmung der Transponderantenne (34) durch Abtrag der Leitermaterialschicht (32) oder durch Abtrennen von Leiterabschnitten mittels des Lasers (29) erfolgt.

11. Verfahren nach Anspruch 10,
**dadurch gekennzeichnet,**
**dass** die Transponderantenne (34) mit vordefinierten Trennbereichen ausgebildet wird, welche mittels des Lasers (29) trennbar sind.

12. Verfahren nach einem der Ansprüche 1 bis 8,
**dadurch gekennzeichnet,**
**dass** die Leiteranordnung (64) als ein Zwischenträger (54) ausgebildet wird.

13. Verfahren nach einem der vorangehenden Ansprüche,
**dadurch gekennzeichnet,**
**dass** der Isolierspalt (42, 43, 59) mit einer Spaltbreite von ≤20 µm ausgebildet wird.

14. Verfahren nach einem der vorangehenden Ansprüche,
**dadurch gekennzeichnet,**
**dass** im Chipkontaktbereich (41) vier isolierte Leiteranschlussflächen (44, 45, 46, 47) ausgebildet werden.

15. Verfahren nach einem der vorangehenden Ansprüche,
**dadurch gekennzeichnet,**
**dass** das Trägersubstrat (35, 55) als ein Folienstreifen mit einer Mehrzahl von in parallelen Reihen angeordneten Leiteranordnungen (33) ausgebildet ist und relativ zum Laser (29) an diesem vorbei bewegt wird.

16. Verfahren nach einem der vorangehenden Ansprüche,
**dadurch gekennzeichnet,**
**dass** vor Kontaktierung eines Chips ein Chip-Zwischenträger kontaktiert wird.

## Claims

1. A method for contacting a chip with a conductor arrangement, in particular a transponder antenna, an intermediate carrier or the like, with a carrier substrate (35, 55) for accommodating the chip and with a chip (51) having chip terminal faces formed thereon, wherein a conductor material layer (32, 66) is formed on the carrier substrate, wherein the conductor material layer forms a conductor arrangement (33, 64) having at least two conductors (39, 40, 56, 57) which are connected to each other in a chip contact area (41, 58), wherein an insulating gap (42, 43, 59) is formed in the chip contact area, such that mutually electrically insulated conductor terminal faces (44, 45, 46, 47, 60, 61) of the conductors are formed, wherein the chip terminal faces are contacted with the conductor terminal faces, wherein the insulating gap is formed by removal of the conductor material layer by means of a laser (29)
**characterised in that**
a relative position of the insulating gap is determined with the aid of an image processing device prior to placement of the chip (51).

2. The method according to claim 1,
**characterised in that**
the chip contact area (41, 58) is cleaned with the aid of a plasma treatment.

3. The method according to claim 1 or 2,
**characterised in that**
an adhesive material (50) is applied onto the chip contact area (41, 58) prior to or subsequent to contacting of the chip (51).

4. The method according to any one of the preceding claims,
**characterised in that**
the relative position is determined prior to or subsequent to the application of an adhesive material (50) onto the chip contact area (41, 58).

5. The method according to any one of the preceding claims,
**characterised in that**
a chip position on the carrier substrate (35, 55) is calculated from data of the image processing device by means of a machine control system.

6. The method according to any one of the preceding claims,
**characterised in that**
the carrier substrate (35, 55) is fixed on a plate (37) with the aid of a liquid film (36) in order to form the insulating gap (42, 43, 59).

7. The method according to any of Claims 1 to 5,
**characterised in that**
the carrier substrate is fixed on a plate by means of negative pressure in order to form the insulating gap.

8. The method according to any one of the preceding claims,
**characterised in that**
the conductor material layer (32, 66) is made of aluminium.

9. The method according to any one of the preceding claims, **characterised in that**
the conductor arrangement (33) is designed as a transponder antenna (34).

10. The method according to claim 9,
**characterised in that**
the frequency of the transponder antenna (34) is tuned by removing the conductor material layer (32) or by separating conductor segments by means of the laser (29).

11. The method according to claim 10,
**characterised in that**
the transponder antenna (34) is designed with pre-defined separating areas which can be separated by means of the laser (29).

12. The method according to any of claims 1 to 8,
**characterised in that**
the conductor arrangement (64) is designed as an intermediate carrier (54).

13. The method according to any one of the preceding claims,
**characterised in that**
the insulating gap (42, 43, 59) is designed with a gap width of ≤20 µm.

14. The method according to any one of the preceding claims,
**characterised in that**
four insulated conductor terminal faces (44, 45, 46, 47) are formed in the chip contact area (41).

15. The method according to any one of the preceding claims,
**characterised in that**
the carrier substrate (35, 55) is designed as a film strip having a plurality of conductor arrangements (33) disposed in parallel rows and is moved relative to the laser (29) so as to be moved past the same.

16. The method according to any one of the preceding claims,
**characterised in that**
a chip intermediate carrier is contacted prior to contacting of a chip.

## Revendications

1. Procédé de mise en contact d'une puce avec un agencement de conducteurs, en particulier avec une antenne de transpondeur, avec un support intermédiaire ou quelque chose de similaire, incluant un substrat porteur (35, 55) pour loger la puce et incluant une puce (51) ayant des surfaces de raccordement de la puce formées sur cette dernière, dans lequel une couche (32, 66) de matériau conducteur est formée sur le substrat porteur, dans lequel la couche de matériau conducteur forme un agencement (33, 64) de conducteurs incluant au moins deux conducteurs (39, 40, 56, 57) qui sont connectés l'un à l'autre dans une zone (41, 58) de contact de la puce, dans lequel une fissure (42, 43, 59) isolante est formée dans la zone de contact de la puce, tellement que des surfaces (44, 45, 46, 47,60, 61) de raccordement des conducteurs sont formées qui sont isolées électriquement les unes des autres et qui appartiennent aux conducteurs, dans lequel les surfaces de raccordement de la puce sont mises en contact avec les surfaces de raccordement des conducteurs, dans lequel la fissure isolante est formée en décapant la couche de matériau conducteur au moyen d'un laser (29),
**caractérisé en ce qu'**
avant de placer la puce, une position relative de la fissure isolante est déterminée à l'aide d'un dispositif de traitement d'images.

2. Procédé selon la revendication 1,
**caractérisé en ce que**
la zone (41, 58) de contact de la puce est nettoyée à l'aide d'un traitement à plasma.

3. Procédé selon la revendication 1 ou 2,
**caractérisé en ce qu'**
avant ou après une mise en contact de la puce (51), du matériau adhésif (50) est appliqué sur la zone (41, 58) de contact de la puce.

4. Procédé selon l'une quelconque des revendications précédentes,
**caractérisé en ce que**
la position relative est déterminée avant ou après que du matériau adhésif (50) soit appliqué sur la zone (41, 58) de contact de la puce.

5. Procédé selon l'une quelconque des revendications précédentes,
**caractérisé en ce qu'**
à l'aide d'une commande à machine, une position de la puce sur le substrat porteur (35, 55) est calculée à partir de données provenant du dispositif de traitement d'images.

6. Procédé selon l'une quelconque des revendications précédentes,
**caractérisé en ce que**
pour former la fissure (42, 43, 59) isolante, le substrat porteur (35, 55) est fixé sur une plaque (37) à l'aide d'un film (36) de liquide.

7. Procédé selon l'une quelconque des revendications 1 à 5,
**caractérisé en ce que**
pour former la fissure isolante, le substrat porteur est fixé sur une plaque par dépression.

8. Procédé selon l'une quelconque des revendications précédentes,
**caractérisé en ce que**
la couche (32, 66) de matériau conducteur est formée d'aluminium.

9. Procédé selon l'une quelconque des revendications précédentes,
**caractérisé en ce que**
l'agencement (33) de conducteurs est conçu comme une antenne (34) de transpondeur.

10. Procédé selon la revendication 9,
**caractérisé en ce qu'**
une fréquence de l'antenne (34) de transpondeur est accordée en décapant la couche (32) de matériau conducteur ou en décousant des sections de conducteurs au moyen du laser (29).

11. Procédé selon la revendication 10,
**caractérisé en ce que**
l'antenne (34) de transpondeur est conçue avec des zones à découdre qui sont prédéfinies et qui peuvent être décousues au moyen du laser (29).

12. Procédé selon l'une quelconque des revendications 1 à 8,
**caractérisé en ce que**
l'agencement (64) de conducteurs est conçu comme un support intermédiaire (54).

13. Procédé selon l'une quelconque des revendications précédentes,
**caractérisé en ce que**
la fissure (42, 43, 59) isolante est conçue avec une largeur de fissure de ≤20 µm.

14. Procédé selon l'une quelconque des revendications précédentes,
**caractérisé en ce que**
quatre surfaces (44, 45, 46, 47) de raccordement des conducteurs isolées sont formées dans la zone (41) de contact de la puce.

15. Procédé selon l'une quelconque des revendications précédentes,
**caractérisé en ce que**
le substrat porteur (35, 55) est conçu comme un ruban de film incluant une multiplicité d'agencements (33) de conducteurs qui sont disposés en lignes parallèles et **en ce qu'**il est mu relatif au laser (29), en passant ce dernier.

16. Procédé selon l'une quelconque des revendications précédentes,
**caractérisé en ce qu'**
avant la mise en contact d'une puce, un support intermédiaire de puce est mis en contact.
